# FASCICULE DE BREVET EUROPEEN

(11) **EP 2 840 589 B1**
(45) Date de publication et mention de la délivrance du brevet: **25.05.2016**
(21) Numéro de dépôt: 14181272.7
(22) Date de dépôt: 18.08.2014
(51) Int. Cl.: H01L 21/02, B81C 1/00, H01L 21/762, H01L 27/146

(54) **Procédé améliore de séparation entre une zone activé d'un substrat et sa face arrière ou une portion de sa face arrière**
Verbessertes Verfahren zur Trennung zwischen einer aktiven Zone eines Substrats und dessen Rückseite oder eines Teilbereichs seiner Rückseite
Improved separation method between an active area of a substrate and the rear surface thereof or a portion of the rear surface thereof

(30) Priorité: 20.08.2013 FR 1358080
(43) Date de publication de la demande: 25.02.2015
(73) Titulaire: Commissariat à l'Énergie Atomique et aux Énergies Alternatives, 75015 Paris (FR)
(72) Inventeur: Grenouillet, Laurent, 38000 Grenoble (FR); Vinet, Maud, 44690 La Haye Fouassiere (FR)
(74) Mandataire: Brevalex

(56) Documents cités:
- EP-A1- 1 043 769
- WO-A1-2005/093824
- WO-A1-2007/072406
- US-A1- 2010 283 147

## Description

### DOMAINE TECHNIQUE ET ART ANTERIEUR

La présente invention a trait à la micro-électronique, et se rapporte plus particulièrement au domaine des procédés de fabrication des dispositifs microélectroniques.

Dans ce domaine, on cherche de plus en plus à réduire l'encombrement des dispositifs tout en augmentant la densité d'intégration de leurs composants.

Pour cela, il est notamment connu de vouloir réaliser des dispositifs dits « 3D » formés d'empilements de substrats dotés chacun d'une couche dite « active », c'est à dire dans laquelle des composants sont au moins partiellement formés.

Pour réduire l'épaisseur totale de ces empilements, on peut chercher à n'empiler que les couches actives des substrats, qui sont généralement fines, par exemple inférieure à 100 µm, en retirant une partie inutile ou devenue inutile de ces substrats, et dont l'épaisseur totale peut dépasser plusieurs centaines de micromètres et est comprise par exemple entre 400 µm et 800 µm.

Une technique connue pour dissocier une couche active d'un substrat d'une couche ayant servie de support, consiste à réaliser une implantation, par exemple à base d'hydrogène, entre cette couche active et cette couche de support de manière à créer une zone de fragilisation et pouvoir séparer la couche active au niveau de cette zone de fragilisation par exemple par traitement thermique et/ou mécanique.

Les documents US 2005/0148163 A1, US 2008/0064182 A1, WO 2009/069709A1 présentent par exemple des procédés de fabrication utilisant une telle technique, et dans lesquels un substrat poignée accolé à la couche active peut être utilisé pour favoriser le détachement entre la couche active et la couche de support.

Cette technique a notamment pour inconvénients de générer des défauts dans la couche active du fait notamment que les espèces implantées traversent cette couche active.

Une autre technique de séparation s'applique aux substrats de type semi-conducteur sur isolant, c'est-à-dire aux substrats comprenant une couche de support, recouverte d'une couche isolante, elle-même recouverte d'une couche semi-conductrice destinée à former une couche active.

Cette autre technique consiste à graver la couche de support jusqu'à atteindre la couche isolante, par exemple par meulage (« grinding » selon la terminologie anglo-saxonne) puis gravure en se servant de la couche isolante comme couche d'arrêt.

Cependant, un tel type de procédé a pour inconvénient de supprimer entièrement la couche de support, ce qui peut s'avérer très couteux. Elle ne peut par ailleurs pas s'appliquer aux dispositifs dans lesquels la couche de support comporte une partie utile, c'est-à-dire une partie dans laquelle au moins un élément actif ou passif est destiné à être au moins partiellement formé.

Il se pose donc le problème de trouver un nouveau procédé microélectronique, qui ne comporte pas les inconvénients mentionnés ci-dessus, et permette de dissocier la couche active d'un substrat d'une autre portion du substrat servant de support afin d'amincir ce substrat.

Plus généralement, il se pose le problème de trouver un nouveau procédé permettant de réaliser une zone de séparation entre la couche active d'un substrat et une autre portion du substrat servant de support.

Les documents WO 2007/072406 et US 2010 décrivent tous deux des procédés différents permettant de dissocier une couche de son substrat en formant des cavités sous la couche active.

### EXPOSÉ DE L'INVENTION

La présente invention prévoit tout d'abord un procédé permettant de réaliser une séparation et éventuellement d'isoler une zone active d'un substrat située du côté de sa face avant, d'une portion du substrat située du côté de sa face arrière et servant de support.

La présente invention concerne ainsi un procédé de réalisation d'un dispositif microélectronique comprenant des étapes consistant à :
- réaliser une pluralité de tranchées du côté d'une face avant d'un substrat, comportant une zone active dans laquelle un ou plusieurs composants sont prévus,
- former dans le prolongement desdites tranchées, des cavités élargies par rapport aux tranchées de sorte qu'au moins une cavité donnée formée dans le prolongement d'une tranchée donnée est réalisée à côté d'une autre cavité formée dans le prolongement d'une autre tranchée adjacente de ladite tranchée donnée,
- remplir lesdites cavités à l'aide d'au moins un matériau donné.

Par tranchée, on entend une cavité s'étendant sensiblement perpendiculairement au plan principal du substrat

Par cavités élargies par rapport aux tranchées on entend une cavité dont les dimensions dans le plan du substrat sont supérieures à celles de la tranchée.

Les cavités remplies du matériau donné forment une séparation entre ladite zone active et une portion donnée du substrat située au niveau de sa face arrière et formée d'un matériau différent dudit matériau donné.

Avantageusement, l'ensemble des cavités réalisé peut être tel qu'au moins une cavité donnée formée dans le prolongement d'une tranchée donnée, débouche latéralement sur une autre cavité, adjacente de ladite cavité donnée, et forme avec cette autre cavité une galerie dans ledit substrat remplie du matériau donné, ladite autre cavité étant formée dans le prolongement d'une autre tranchée adjacente de ladite tranchée donnée.

La galerie remplie du matériau donné forme dans ce cas une séparation continue entre ladite zone active et une portion donnée du substrat à base d'un autre matériau différent dudit matériau donné et située du côté de la face arrière du substrat, opposée à ladite face avant.

La présente invention prévoit également un procédé permettant de dissocier la zone active du substrat d'une portion donnée du substrat située du côté de sa face arrière.

Pour cela, on effectue, après remplissage des cavités, un retrait d'une portion donnée du substrat située en regard desdites tranchées et du côté d'une face arrière du substrat, opposée à ladite face avant, ladite portion étant à base d'un autre matériau différent dudit matériau donné.

La présente invention prévoit ainsi également un nouveau procédé d'amincissement d'un substrat par sa face arrière.

Pour cela, après l'étape de remplissage des cavités, le procédé peut comprendre en outre une étape consistant à retirer ladite portion donnée du substrat.

Un tel procédé peut être mis en oeuvre sur un substrat de type semi-conducteur sur isolant, tel qu'un substrat SOI.

Un tel procédé permet, lorsqu'il est mis en oeuvre sur un substrat semi-conducteur sur isolant, d'effectuer un retrait d'une portion de la face arrière du substrat tout en préservant la couche isolante du substrat, qui est par exemple une couche d'oxyde enterré dans le cas d'un substrat SOI.

Un tel procédé permet également d'effectuer un retrait d'une portion de la face arrière d'un substrat semi-conducteur sur isolant, tout en préservant une partie de sa couche semi-conductrice de support située sous la couche isolante du substrat.

Le procédé peut s'appliquer également à d'autres types de substrats, par exemple à des substrats massifs (« bulk » selon la terminologie anglo-saxonne).

Selon une première possibilité de mise en oeuvre de l'étape de retrait de ladite portion donnée du substrat, cette étape comprend une gravure sélective dudit autre matériau du substrat vis-à-vis dudit matériau donné de remplissage des cavités, ou un retrait dudit autre matériau du substrat, en particulier par gravure ou polissage, jusqu'à atteindre ledit matériau donné de remplissage des cavités en face arrière du substrat, ledit matériau donné servant alors de matériau d'arrêt à ladite gravure ou audit polissage.

Par polissage, on entend une étape d'enlèvement essentiellement mécanique qui regroupe également du meulage ou de la rectification et qui peut éventuellement être assistée chimiquement.

Avantageusement, le retrait de ladite portion donnée du substrat peut être réalisé par :
- formation d'un masquage protégeant une zone donnée de la face arrière du substrat, une autre zone de la face arrière étant dévoilée, puis
- gravure de cette autre zone à travers le masquage.

On peut ainsi effectuer un retrait d'une portion localisée du substrat au niveau de sa face arrière, sans graver l'ensemble de la face arrière.

Le procédé peut comprendre en outre, après retrait de ladite portion : une étape de planarisation dudit matériau donné en face arrière du substrat.

Après avoir retiré une portion du substrat au niveau de sa face arrière, on peut ainsi préparer cette face arrière dévoilant le matériau donné en vue d'un dépôt ultérieur d'une ou plusieurs couches ou d'un assemblage avec un autre support.

Le procédé peut alors comprendre en outre, après planarisation dudit matériau donné, une étape consistant à déposer au moins une couche du côté de la face arrière du substrat, par exemple une couche anti-réfléchissante dans un cas où on réalise un dispositif optique.

En variante, le procédé peut comprendre, après planarisation dudit matériau : une étape consistant à assembler, par exemple par collage direct, un support du côté de la face arrière dudit substrat.

Selon une possibilité de mise en oeuvre du procédé, on peut retirer le matériau donné de remplissage après avoir retiré ladite portion donnée du substrat.

Ce matériau de remplissage peut alors être remplacé par un matériau ayant des propriétés différentes, par exemple un matériau conducteur.

En variante, le retrait du matériau de remplissage est effectué de manière à dévoiler des blocs du substrat dont la forme est complémentaire de celle des cavités, par exemple pyramidale, ces blocs étant destinés à former des dioptres, en particulier des lentilles.

Selon une deuxième possibilité de mise en oeuvre de l'étape de retrait de ladite portion donnée du substrat dans laquelle les cavités sont réalisées de sorte qu'une ou plusieurs débouchent latéralement sur une zone d'une face latérale du substrat, le retrait peut être réalisé par gravure sélective dudit matériau donné vis-à-vis dudit autre matériau.

La séparation entre la zone active et la portion donnée du substrat peut être ainsi réalisée en retirant le matériau de remplissage des cavités.

Selon une possibilité de mise en oeuvre du procédé de l'étape de retrait de ladite portion donnée du substrat, on peut effectuer un retrait dit « pleine plaque », lorsque ladite portion retirée en face arrière a une surface égale à la surface totale de la face avant mesurée parallèlement au plan principal du substrat.

Selon une possibilité de mise en oeuvre du procédé, les étapes consistant à réaliser lesdites tranchées, former lesdites cavités élargies, et remplir lesdites cavités, peuvent être réalisées en plusieurs séquences et comprendre :
- la réalisation d'une première pluralité de tranchées du côté de la face avant du substrat,
- la formation dans le prolongement desdites premières tranchées, de premières cavités élargies par rapport aux premières tranchées,
- le remplissage desdites premières cavités à l'aide dudit matériau donné,
- la réalisation d'une deuxième pluralité de tranchées du côté de la face avant du substrat,
- la formation dans le prolongement desdites deuxièmes tranchées, de deuxièmes cavités élargies par rapport aux deuxièmes tranchées,
- le remplissage desdites deuxièmes cavités à l'aide dudit matériau donné.

Une telle réalisation en plusieurs temps des tranchées et des cavités est en particulier effectuée lorsqu'on souhaite réalise un retrait « pleine plaque » d'une portion du substrat. Dans ce mode de réalisation, la réalisation en plusieurs fois des tranchées et cavités permet d'assurer une cohésion mécanique de l'ensemble des blocs du substrat autour desquels les tranchées et cavités ont été réalisées par le biais du matériau de remplissage des premières tranchées et des premières cavités. Les premières tranchées et premières cavités remplies de matériau donné forment ainsi des moyens de soutien mécanique aux blocs du substrat autour desquels les tranchées et cavités ont été formées.

Selon une possibilité de mise en oeuvre du procédé, après remplissage des cavités à l'aide dudit matériau donné, on forme une couche protectrice sur la face avant du substrat de manière à boucher lesdites tranchées.

Cette couche protectrice est prévue de sorte que le matériau donné de remplissage peut être gravé de manière sélective vis-à-vis de celui de ladite couche protectrice.

On peut ainsi graver le matériau donné de remplissage par la face arrière du substrat, tout en protégeant sa face avant.

Selon une possibilité de mise en oeuvre, après remplissage des cavités et préalablement au retrait de ladite portion du substrat, un recuit de densification du matériau donné de remplissage desdites cavités peut être effectué.

Ce recuit permet de renforcer la cohésion du matériau de remplissage des cavités.

Selon une possibilité de mise en oeuvre, après remplissage des cavités et préalablement au retrait de ladite portion du substrat, un assemblage d'un substrat poignée en face avant du substrat peut être effectué.

Selon une possibilité de mise en oeuvre du procédé, la tranchée donnée et ladite tranchée adjacente peuvent être prévues avec un espacement p prédéterminé. Les cavités peuvent être alors formées par gravure du substrat de sorte que les cavités comportent des parois réalisant une forme évasée, cette gravure étant prolongée de sorte que la distance Δ séparant les parois atteint une valeur, telle que Δ>p.

Selon une mise en oeuvre particulière du procédé, la portion retirée du substrat peut être à base de Si et d'orientation cristallographique '(100)'. Dans ce cas, les cavités peuvent être formées par gravure selon le plan cristallographique '(111)'.

On peut ainsi réaliser des cavités à parois inclinées selon un angle prédéterminé, par exemple de l'ordre de 52°, par rapport au plan principal du substrat.

Selon une possibilité de mise en oeuvre, le matériau donné de remplissage des cavités peut être un matériau diélectrique tel que du SiO₂.

Dans ce cas, les galeries remplies de matériau diélectrique permettent de réaliser une isolation électrique entre la zone active et ladite portion donnée du substrat.

En variante, le matériau donné de remplissage des cavités peut être un métal. Le procédé peut alors comprendre en outre, après formation des cavités et préalablement à leur remplissage, une étape consistant à former une couche barrière de diffusion tapissant les parois des cavités.

Selon une possibilité de mise en oeuvre, plusieurs desdites cavités peuvent être situées à des profondeurs différentes dans le substrat.

Cela permet également d'effectuer un retrait d'une portion donnée du substrat selon une épaisseur qui n'est pas constante.

Le procédé suivant l'invention peut s'appliquer par exemple à une fabrication d'un dispositif imageur.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1K illustrent un premier exemple de procédé suivant l'invention, permettant de former une zone isolante de séparation entre une couche active d'un substrat et une portion donnée dudit substrat servant de support ;
   les figures 2A-2C illustrent un ensemble d'étapes de procédé qui peuvent être réalisées à la suite du premier exemple de procédé afin de d'amincir ledit substrat en retirant ladite portion donnée ;
- les figures 3A-3E illustrent un deuxième exemple de procédé suivant l'invention, permettant la séparation entre une couche active d'un substrat et une portion dudit substrat servant de support, la séparation étant réalisée par gravure sélective d'un matériau de remplissage de cavités formées dans le substrat ;
- les figures 4 à 7 illustrent différentes variantes de mise en oeuvre de cavités formées dans un substrat en vue d'une séparation entre une couche active du substrat et une portion de ce substrat servant de support ;
- les figures 8A-8D illustrent un troisième exemple de procédé suivant l'invention, permettant de réaliser une séparation entre une couche active d'un substrat dans laquelle des composants ont été formés et une portion donnée dudit substrat servant de support, la séparation étant réalisée par retrait de ladite portion donnée jusqu'à atteindre des cavités formées dans le substrat et remplies d'un matériau donné ;
- la figure 9 illustre une variante de réalisation du troisième exemple de procédé dans lequel après avoir retiré une portion de substrat au niveau de sa face arrière, on accole un autre support sur cette face arrière ;
- la figure 10 illustre une autre variante de réalisation du troisième exemple de procédé dans lequel après avoir retiré une portion de substrat au niveau de sa face arrière, on dépose une couche sur cette face arrière ;
- la figure 11 illustre une autre variante de réalisation du troisième exemple de procédé dans lequel après avoir retiré une portion de substrat au niveau de sa face arrière, on retire le matériau de remplissage des cavités ;
- la figure 12 illustre une autre variante de réalisation du troisième exemple de procédé dans lequel après avoir retiré une portion de substrat au niveau de sa face arrière, on retire le matériau donné de remplissage des cavités, et on remplace ce matériau donné par un autre matériau ayant des propriétés différentes ;
- les figures 13A-13B illustrent un exemple de procédé d'amincissement d'un substrat au niveau d'une portion localisée de sa face arrière ;
- la figure 14 illustre une variante de procédé d'amincissement d'un substrat au niveau d'une zone centrale de sa face arrière, tandis qu'une zone périphérique autour de la zone centrale est conservée ;
- les figures 15A-15B illustrent une variante de procédé d'amincissement d'un substrat au niveau de sa face arrière ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

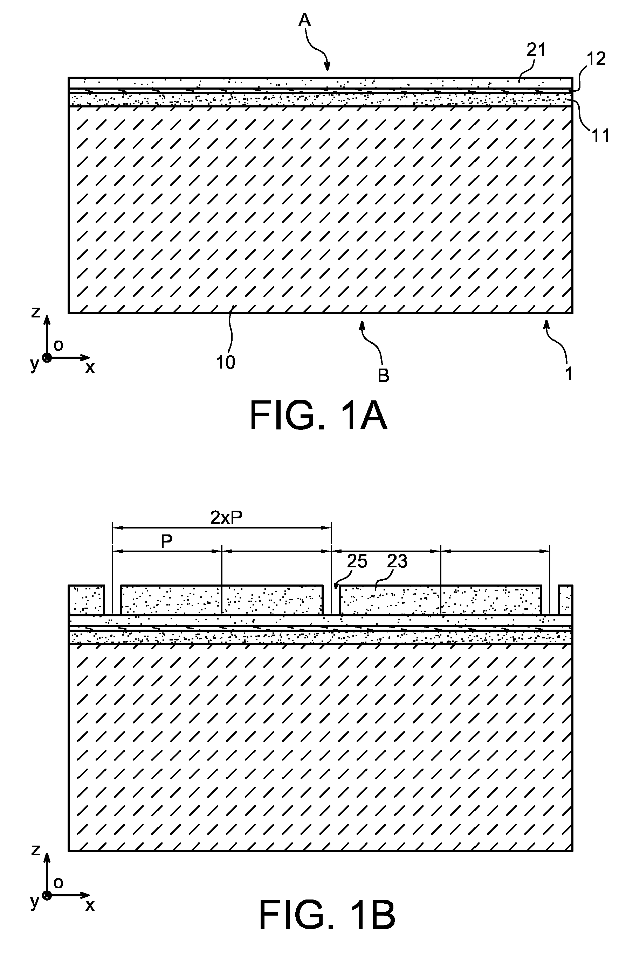

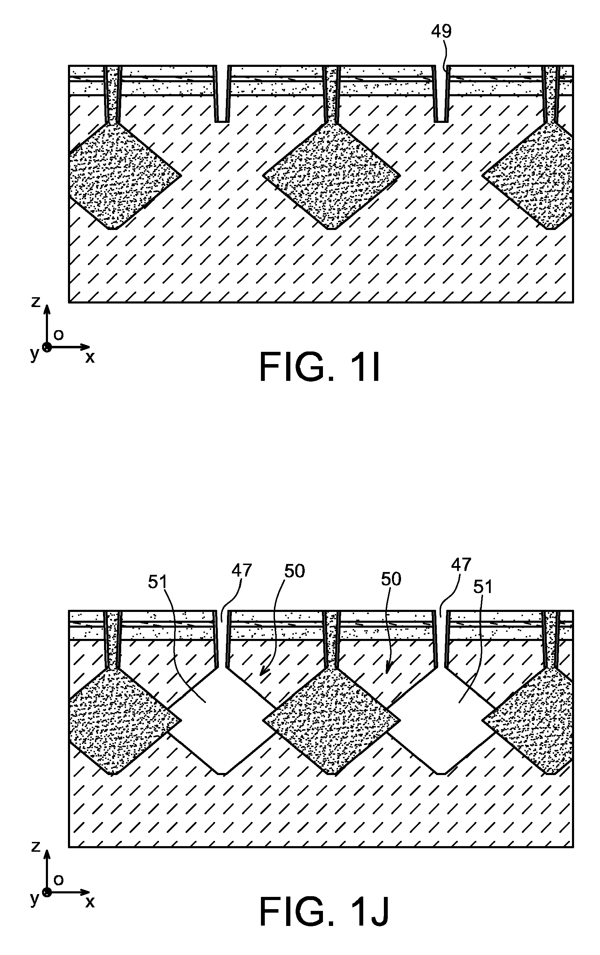

Un premier exemple de procédé, suivant l'invention, va à présent être décrit en liaison avec les figures 1A-1K.

Le matériau de départ de ce procédé peut être par exemple un substrat de type semi-conducteur sur isolant, par exemple de type SOI (SOI pour « silicon on insulator » ou « silicium sur isolant »).

Le substrat 1 comprend ainsi une couche de support par exemple semi-conductrice 10, qui peut être à base de Si, et d'épaisseur (mesurée dans une direction parallèle à l'axe z d'un repère orthogonal [O ;x;y ;z] donné sur la figure 1A) par exemple comprise entre 400 µm et 1 mm.

Le substrat 1 peut comprendre également une couche isolante 11, par exemple à base d'oxyde de silicium, qui est située sur et en contact avec la couche de support 10. La couche isolante 11 peut être par exemple de type BOX (BOX pour « Burried Oxide ») avec une épaisseur par exemple de l'ordre de 145 nm, ou de type TBOX (pour « Thin Burried Oxide ») et d'épaisseur par exemple de l'ordre de 10 nm à 25 nm.

Le substrat 1 comporte en outre une couche semi conductrice 12 dite « superficielle » située sur et en contact avec ladite couche isolante 11. Cette couche semi-conductrice superficielle 12, peut avoir une épaisseur par exemple inférieure à 20 nm, et est destinée à former une couche active permettant d'accueillir des composants ou des parties de composants, par exemple des transistors.

On forme tout d'abord (figure 1A) une couche de masque dur 21, par exemple à base de SiₓN_{y}, sur la couche semi conductrice superficielle 12.

Puis (figure 1B), sur la couche de masque dur 21, on forme un masquage 23, par exemple à base de résine photosensible, comportant des ouvertures 25 espacées entre elles selon un pas prédéterminé. Le pas de répartition des ouvertures 25 peut être par exemple égal à 2*P, avec P un pas de répartition prévu pour des tranchées destinées à être réalisées ultérieurement dans le substrat 1, avec P qui peut être compris par exemple entre 100 nm et 10 µm, par exemple de l'ordre de 1 µm.

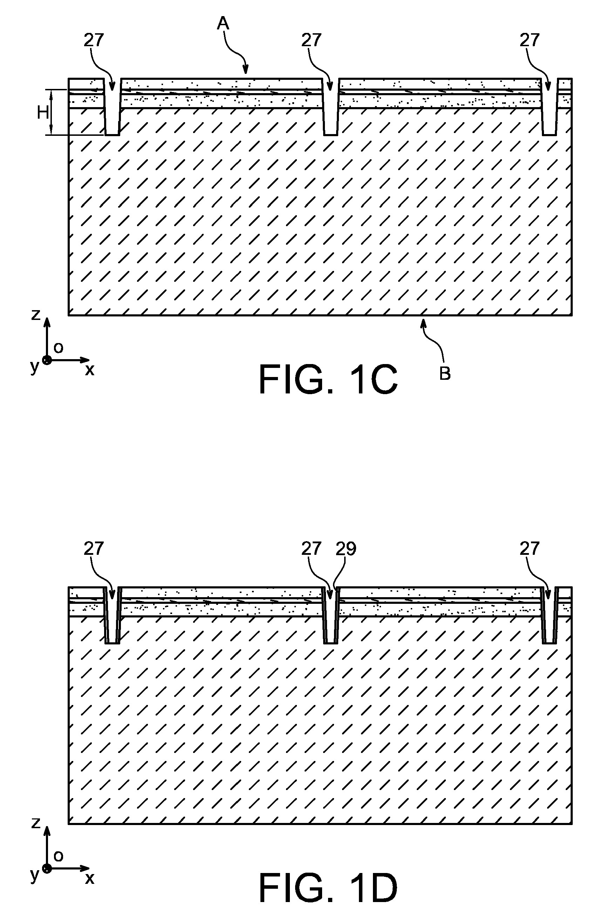

Ensuite (figure 1C), à travers les ouvertures 25 du masquage 23, on effectue une gravure de manière à réaliser une ou plusieurs première(s) tranchée(s) 27 traversant une face A du substrat 1, qui est longitudinale, et appelée « face avant ». Les premières tranchées 27 pénètrent dans l'épaisseur de la couche de support 10 et peuvent être par exemple de type STI (STI pour « shallow trench isolation »), et avoir une profondeur H (mesurée dans une direction parallèle à l'axe z du repère orthogonal [O ;x ;y ;z]) par exemple comprise entre 20 nm et 10 µm, par exemple de l'ordre de 200 nm ou 300 nm. Les premières tranchées 27 sont espacées entre elles selon un pas égal à 2*P.

On forme ensuite une couche de protection 29 (figure 1D) sur les parois verticales des tranchées 27, cette couche étant agencée de sorte que le fond des tranchées 27 n'est pas protégé et dévoile ainsi la couche de support 10 du substrat 1. La couche de protection 29 est à base d'un matériau choisi de sorte qu'une gravure sélective du matériau semi-conducteur de la couche de support 10 peut être effectuée par rapport à celui de la couche de protection 29. Dans le cas, par exemple, où la couche de support 10 est à base de silicium, la couche de protection 29 peut être à base d'un matériau diélectrique tel que du SiₓN_{y} ou du SiO₂, ou du HfO₂. La couche de protection 29 peut être réalisée par dépôt, par exemple à l'aide d'une technique de type ALD (ALD pour « Atomic Layer Deposition »), puis gravure au fond des tranchées 27, par exemple à l'aide d'un plasma, de manière à dévoiler le fond des tranchées 27. La couche de protection 29 peut avoir une épaisseur comprise par exemple entre 3 nm et 20 nm.

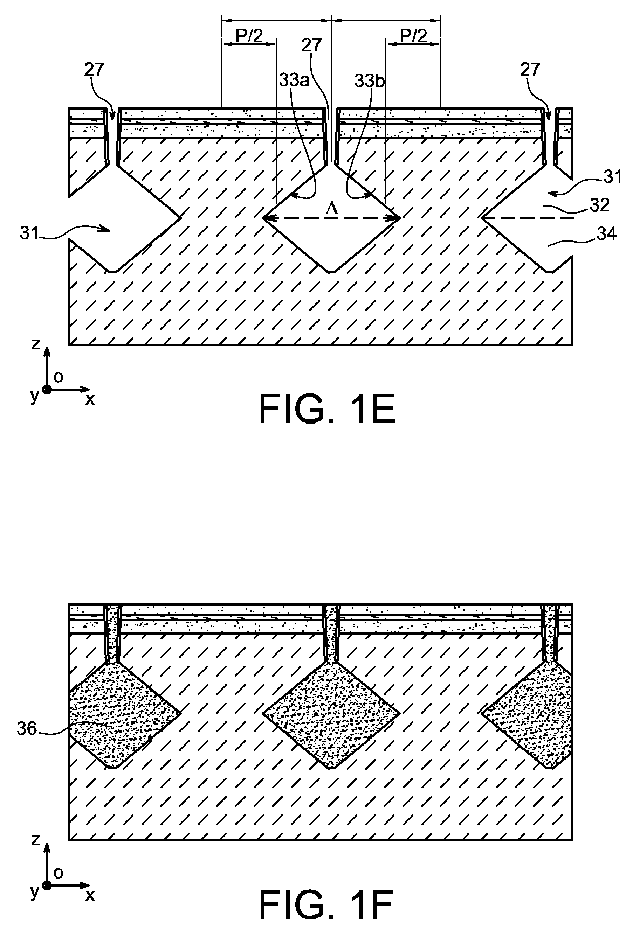

Puis, dans le prolongement des premières tranchées 27 on forme des premières cavités 31 (figure 1E). Ces premières cavités 31 sont réalisées de manière à comporter une première partie 32 de forme évasée ou élargie par rapport à celle des premières tranchées 27. La première partie 32 des cavités 31 a ainsi une section transversale (mesurée dans une direction parallèle au plan principal du substrat, le plan principal du substrat étant défini ici et dans tout le reste de la description comme un plan passant par le substrat et parallèle au plan [O,x,y] indiqué sur la figure 1E) qui augmente, depuis une zone située à la jonction avec les tranchées 27, vers une autre zone située à une profondeur plus importante de la couche de support 10 (la profondeur étant une dimension mesurée ici par rapport à la face avant A du substrat 1).

Dans l'exemple de réalisation illustré sur la figure 1E, la section transversale de la première portion 32 des cavités croit linéairement, lorsqu'on suit un axe de direction orthogonale au plan principal du substrat 1 et de sens allant de la face avant A vers une face B du substrat 1 opposée à la face avant, et appelée « face arrière ». Ainsi, la première partie 32 des cavités 31 comporte des parois inclinées 33a, 33b réalisant un angle non nul, par exemple de l'ordre de 52° avec un plan parallèle au plan principal du substrat 1.

Une telle forme des cavités 31 peut être obtenue par exemple lorsque la couche de support 10 est du silicium d'orientation cristallographique <100>, et qu'une gravure suivant le plan <111> est réalisée. Cette gravure peut être effectuée par exemple à l'aide de HCl en phase gazeuse ou bien de BHF-NH₄OH en phase liquide, ou à l'aide de KOH ou de TMAH.

La gravure permettant de réaliser les cavités 31, est avantageusement prolongée de sorte que la première partie 32 évasée atteint une largeur Δ entre ses parois 33a, 33b (dimension des cavités mesurée dans une direction parallèle au plan principal du substrat) telle que Δ > P.

Les cavités 31 peuvent également avoir une deuxième partie 34 de forme symétrique de celle de la première partie 32 par rapport à un axe parallèle au plan principal du substrat 1.

On effectue ensuite (figure 1F), un remplissage des tranchées 27 et des cavités 31 à l'aide d'un matériau donné 36, différent celui de la couche de support 10.

Dans cet exemple de réalisation, le matériau 36 donné de remplissage est choisi de sorte que le matériau semi-conducteur de la couche de support 10 peut être gravé de manière sélective vis-à-vis de ce matériau 36. Le matériau donné 36 peut être un matériau diélectrique tel que par exemple du SiO₂ ou un diélectrique low-K tel que du SiOC, ou HfO₂. Afin de faciliter le remplissage, un dépôt à la tournette ou un procédé suivant la technologie HARP™ (pour « High Aspect Ratio Process ») peut être effectué. On peut également envisager un matériau tel que le HSQ (pour « Hydrogen SilsesQuioxane ») ou plus généralement un matériau de type SOG (Spin On Glass).

Ensuite, un recuit de densification du matériau 36 de remplissage peut être effectué. Ce recuit peut être réalisé à une température prévue en fonction du matériau de remplissage 36 utilisé, et peut être comprise entre 300°C et 1100°C, par exemple à une température de l'ordre de 1050°C et pendant une durée par exemple de l'ordre de 30 minutes lorsque le matériau 36 donné est du SiO₂.

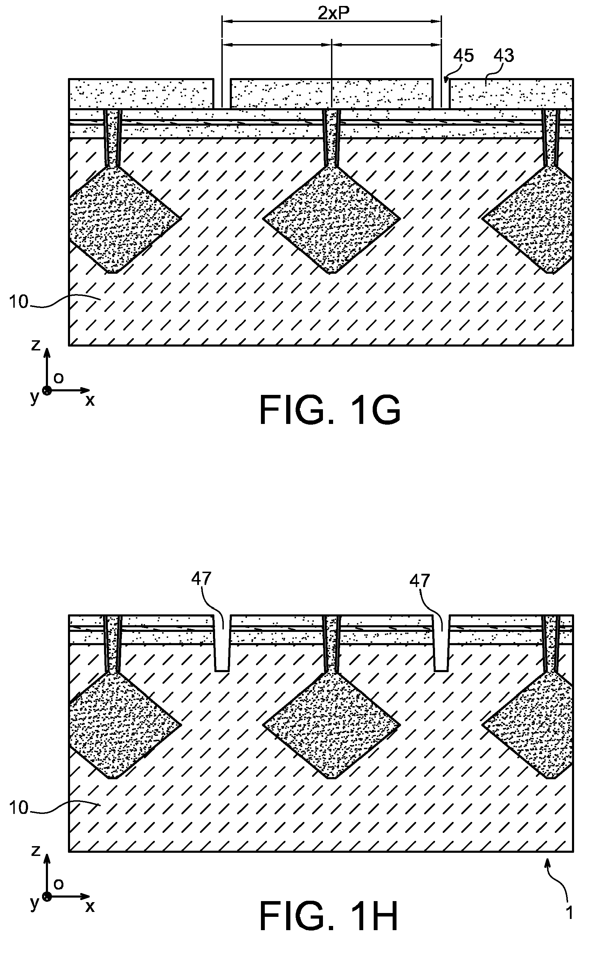

Puis, on forme un deuxième masquage 43 comportant des ouvertures 45, disposées en regard de zones non-gravées de la couche de support 10 et espacées entre elles selon un pas égal à 2*P (figure 1G).

On effectue ensuite une gravure du substrat 1 à travers les ouvertures 45 du masquage 43, de manière à former une ou plusieurs deuxième(s) tranchée(s) 47 dont le fond se situe dans la couche de support 10 du substrat 1. Le masquage 43 peut être ensuite retiré (figure 1H).

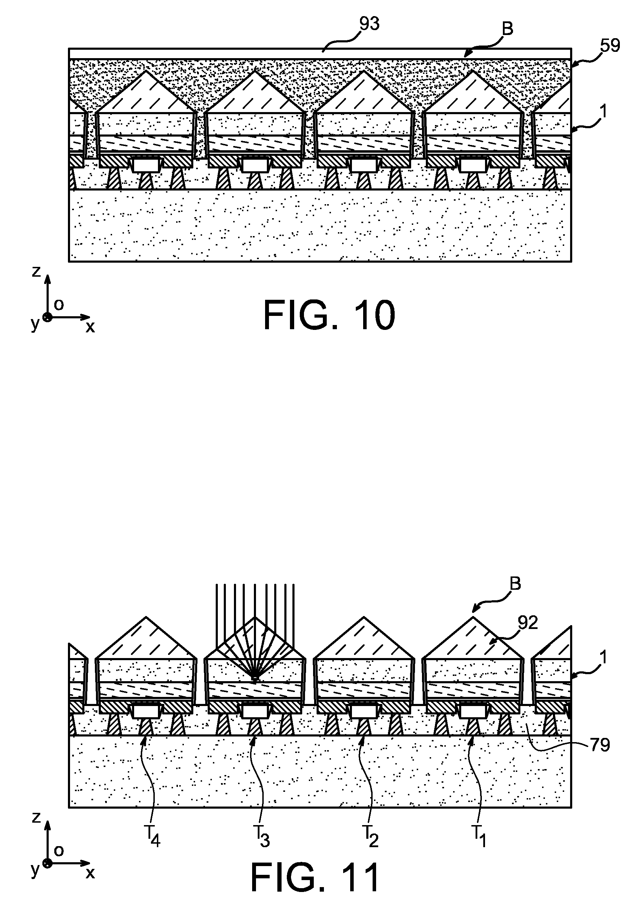

On peut ensuite former une couche de protection 49 sur les parois verticales des deuxièmes tranchées 47, semblable à la couche de protection 29 réalisée pour les premières tranchées 27 (figure 11).

Puis, dans le prolongement des deuxièmes tranchées 47, on réalise des deuxièmes cavités 51 (figure 1J). Les deuxièmes cavités 51 peuvent avoir une forme semblable à celle des premières cavités 31 formées précédemment et comportent ainsi une première partie sur laquelle les deuxièmes tranchées 47 débouchent et une forme évasée ou élargie de section transversale croissante. L'espacement des deuxièmes tranchées 47 par rapport aux premières tranchées 27, est prévu de sorte que les deuxièmes cavités 51 communiquent avec des premières cavités 31 adjacentes réalisées précédemment. La gravure des deuxièmes cavités 51 est ainsi réalisée de sorte que les deuxièmes cavités 51 débouchent sur le matériau 36 de remplissage des premières cavités 31 adjacentes réalisées précédemment.

Le matériau 36 de remplissage des premières tranchées 27 et cavités 31 sert de soutien mécanique à des blocs 50 du substrat autour desquels les deuxièmes tranchées 47 et deuxièmes cavités 51 sont réalisées.

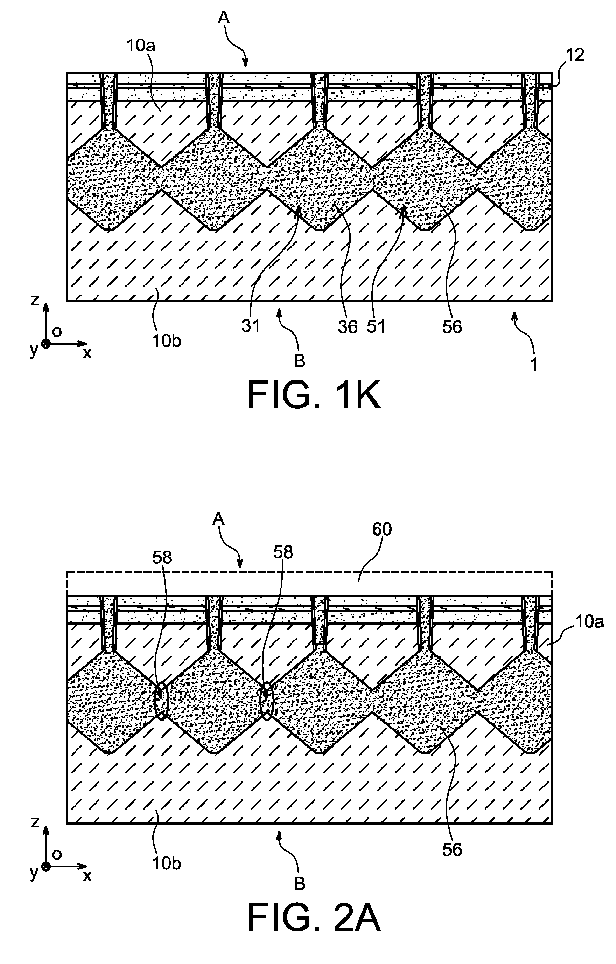

Ensuite (figure 1K), on remplit les deuxièmes cavités 51 à l'aide d'un matériau donné 56 qui peut être semblable ou identique au matériau 36 de remplissage des premières cavités 31. En variante, le matériau 56 de remplissage des deuxièmes cavités peut être différent du matériau 36 de remplissage des premières cavités. Il peut néanmoins être avantageux dans ce cas que ce matériau 56 présente des propriétés de gravure semblables à celles du matériau 36, notamment en ce qui concerne la sélectivité de gravure vis-à-vis du matériau de la couche de support 10.

Le remplissage peut être suivi d'une étape de planarisation par polissage mécano-chimique (CMP) de manière à retirer le matériau 56 de remplissage éventuellement situé sur la face avant A du substrat 1.

Un recuit, afin de densifier le matériau de remplissage 56 peut être ensuite effectué. Ce recuit peut permettre de sceller entre elles des zones 58 de matériau 36 et 56 situées à la jonction entre des cavités adjacentes.

On a ainsi réalisé par le biais de cavités 31, 51 communiquant entre elles dans la couche de support 10 du substrat semi-conducteur, un tunnel ou une galerie remplie d'au moins un matériau donné 36, 56, différent de celui de la couche de support.

Cette galerie forme une séparation entre une portion donnée 10b de la couche de support 10 située du côté de sa face arrière et une autre portion 10a de cette couche de support sur laquelle repose la fine couche semi-conductrice 12 destinée à former une couche active.

En fonction de la manière dont les cavités ont été réalisées, en particulier du nombre de cavités, de leur pas de répartition et de leurs dimensions, la galerie de séparation peut s'étendre parallèlement au plan du substrat (i.e. mesurée parallèlement au plan [O ;x ;y] sur la figure 1K) sur une surface égale à celle de la face avant.

Dans cet exemple, où le matériau donné 36, 56 est diélectrique, la galerie remplie de matériau 36, 56 forme une isolation électrique entre la couche active et la portion donnée 10b du substrat 1.

On peut ensuite éventuellement vouloir ensuite amincir le substrat 1 par sa face arrière B.

Pour cela, on peut ensuite former un support poignée 60 sur la face avant A du substrat 1. Le support poignée 60 peut être par exemple une couche de matériau polymère déposée ou une couche isolante, par exemple à base de SiO₂, réalisée à l'aide d'un collage direct, c'est-à-dire sans matériau intermédiaire pour assurer la cohésion (figure 2A).

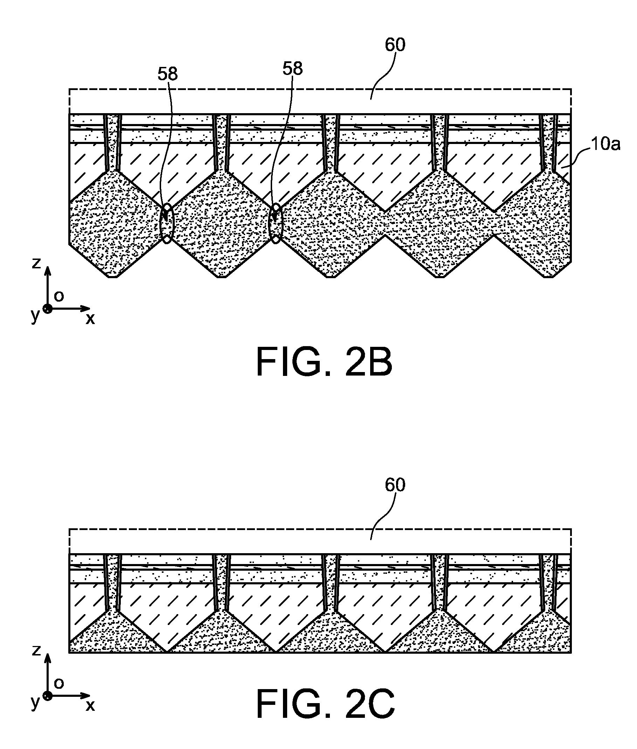

Puis (figure 2B), on retire la portion donnée 10b de la couche de support 10 du substrat 1 au niveau de sa face arrière B. Pour cela, un procédé de meulage (« grinding » selon la terminologie anglo-saxonne) de la face arrière B, éventuellement couplé ou suivi d'une gravure chimique, par exemple à l'aide de TMAH, peut être effectué. La gravure au niveau de la face arrière B est poursuivie jusqu'à atteindre le ou les matériaux 36, 56 de remplissage des cavités 31, 51 qui sert alors d'arrêt à la gravure. La portion 10b retirée de la couche 10 de support du substrat 1 peut avoir une épaisseur comprise par exemple entre 100 µm et 700 µm.

Dans cet exemple de réalisation, le retrait effectué est un retrait dit « pleine plaque » de sorte que la portion 10b retirée s'étend sur une surface égale à celle de la face avant du substrat (mesurée parallèlement au plan [O ;x ;y] sur la figure 2B).

Ensuite (figure 2C), on peut effectuer une étape de planarisation de la face arrière B du substrat 1 par polissage de type CMP du ou des matériaux de remplissage 36, 56 des cavités 31, 51.

On obtient à l'issue de cette étape, un substrat 1 aminci dont une portion importante de la couche de support 10 a été supprimée, sans pour autant la retirer sur toute son épaisseur, une portion 10a située entre le matériau 36, 56 donné de remplissage et la couche active ayant été ici conservée.

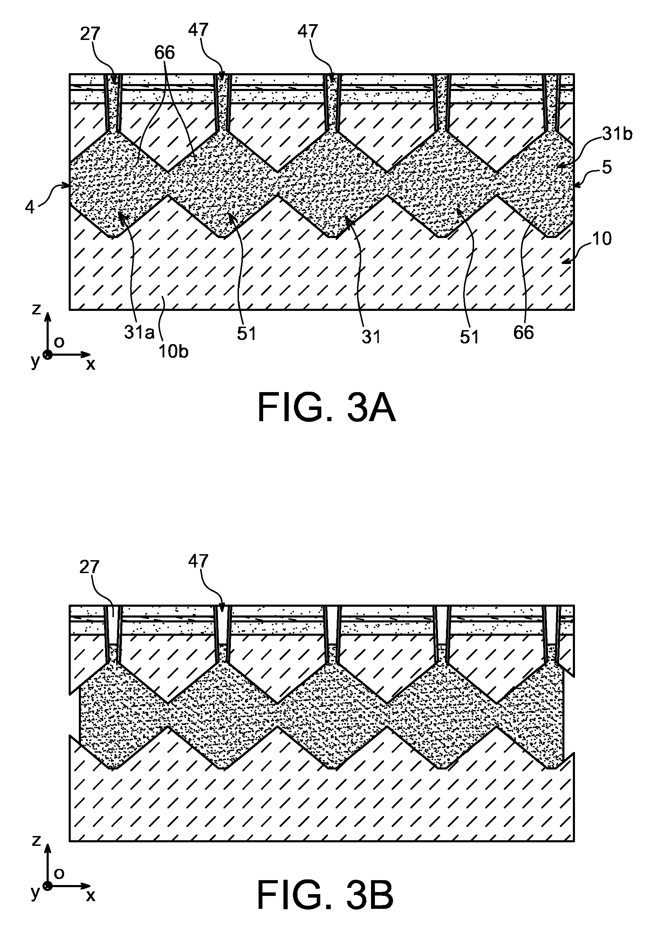

Un autre exemple de réalisation est illustré sur les figures 3A-3E. Dans cet exemple, les cavités formées dans le prolongement de tranchées sont réalisées de sorte qu'au moins une cavité 31a et au moins une autre cavité 31b débouchent respectivement sur une première zone 4 et sur une deuxième zone 5 d'une face latérale du substrat 1, lesdites première zone 4 et deuxième zone 5 étant situées au niveau de la couche de support 10.

Un matériau 66 de remplissage des tranchées 27, 47 et des cavités 31, 51 est dans cet exemple choisi de manière à pouvoir être gravé de manière sélective vis-à-vis du matériau de la couche de support 10. Ce matériau 66 peut être par exemple du SiO₂, lorsque la couche de support 10 est à base de Si.

L'agencement des cavités 31, 51, formées dans la couche de support 10, est tel qu'elles communiquent entre elles, de manière à former une galerie continue ou un tunnel dans la couche de support 10, qui s'étend entre la première zone 4 d'une face latérale du substrat 1 et la deuxième zone 5 d'une face latérale du substrat 1, cette galerie étant remplie de matériau 66 apte à être gravé de manière sélective vis-à-vis du matériau de la couche de support 10 (figure 3A). La galerie remplie de matériau 66 et qui s'étend dans une direction longitudinale du substrat, permet d'établir une séparation entre une portion 10a de la couche de support 10 sur laquelle repose la couche active que l'on souhaite conserver, et une portion 10b de la couche de support 10 du substrat 1 que l'on souhaite retirer.

Après remplissage des tranchées et des cavités, on peut retirer une partie du matériau 66 de remplissage situé dans les tranchées 27, 47, par exemple en effectuant une gravure à l'aide de HF (figure 3B).

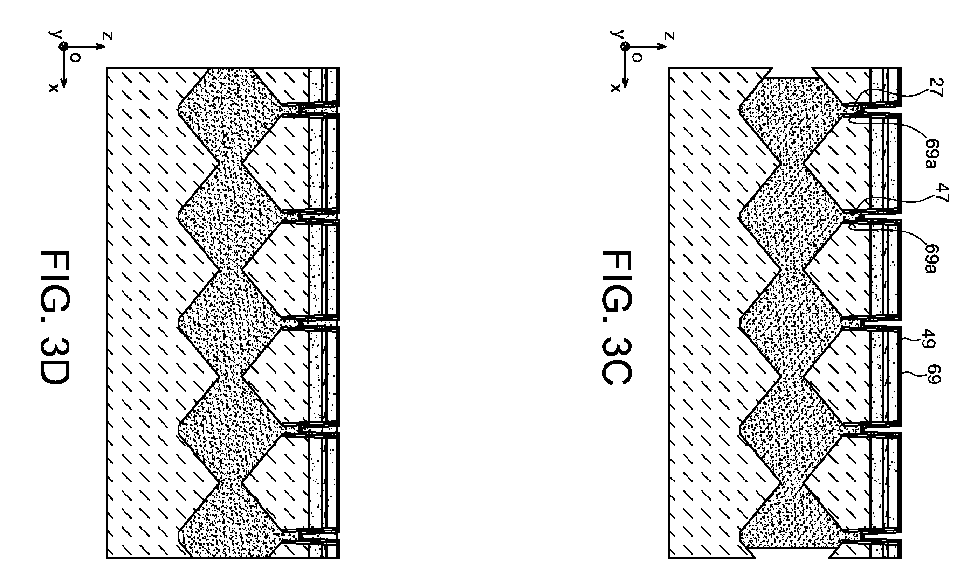

On forme ensuite sur la face avant du substrat 1, une couche protectrice 69, à base d'un matériau prévu pour résister à une gravure du matériau 66 de remplissage des cavités 31, 51. Cette couche protectrice 69 peut être par exemple à base de nitrure de silicium ou d'un matériau High-K tel que du HfO₂, en particulier lorsque le matériau de remplissage 66 est à base de SiO₂. La couche protectrice 69 permet de recouvrir le matériau de remplissage 66 situé dans les tranchées 27, 47, et de former des bouchons 69a de protection dans les tranchées 27, 47 (figure 3C).

Ensuite, les tranchées tapissées par la couche de protection 69, peuvent être comblées à nouveau par le matériau 66 de remplissage, par exemple du SiO₂ (figure 3D). Un tel remplissage peut être prévu pour mettre en oeuvre une surface plane en face avant.

Une planarisation par polissage CMP du matériau 66 de remplissage peut être ensuite effectué au niveau de la face avant A du substrat 1.

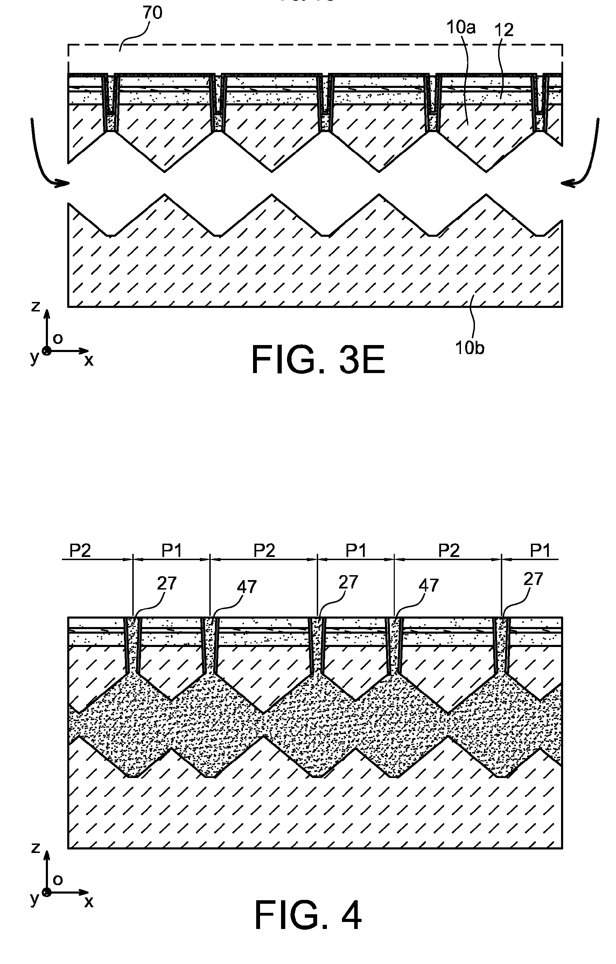

Puis, on effectue un retrait du matériau de remplissage 66 des cavités (figure 3E). Un accès au matériau 66 est permis au niveau des zones 4, 5 situées sur une face latérale du substrat 1, et sur lesquelles les cavités 31a, 31b débouchent. Ce retrait peut être réalisé à l'aide d'une attaque chimique par exemple à l'aide de HF lorsque le matériau 66 est à base de SiO₂. La couche 69 formée précédemment en face avant A du substrat sert de protection lors de l'attaque chimique. Pour protéger le matériau formé dans les tranchées un masquage 70 formé préalablement en face avant peut avoir été prévu.

Du fait de la continuité de la galerie réalisée entre les zones 4, 5 latérales du substrat, cette gravure permet de réaliser un retrait d'une épaisseur de la couche de support 10 au niveau de la face arrière du substrat 1, en particulier sur toute l'étendue de la face arrière (figure 3E).

Les tranchées réalisées préalablement aux cavités ne sont pas nécessairement toutes espacées d'un même pas P. Une variante de réalisation des exemples de procédés décrits précédemment et illustrée sur la figure 4, et prévoit des tranchées adjacentes 27, 47, espacées par exemple soit d'un premier espacement P1 soit d'un deuxième espacement P2, différent de P1 et tel que P2>P1, les premières tranchées 27 étant réparties selon un pas P1+P2 les deuxièmes tranchées 47 étant également réparties selon un pas P1+P2.

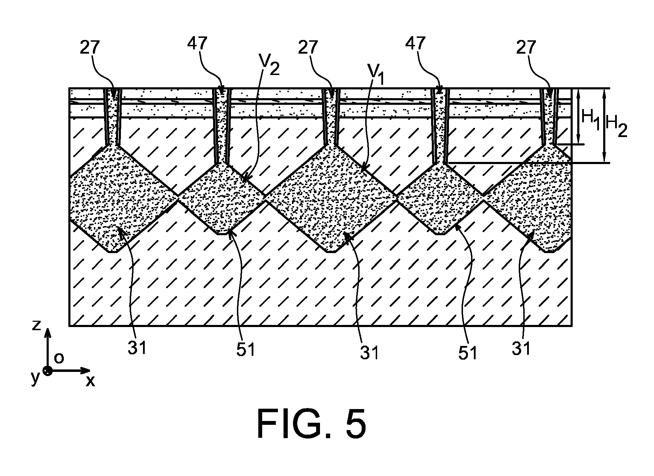

Un autre exemple de réalisation est donné sur la figure 5, avec des premières tranchées 27 et des deuxièmes tranchées 47 de hauteurs respectives H₁, H₂ différentes, par exemple telles que H₁ <H₂. Dans cet exemple, le volume occupé par les cavités diffère d'une cavité à l'autre, les premières tranchées 27 communiquant avec des cavités 31 ayant un volume V₁ donné, tandis que les deuxième tranchées 47 communiquent avec des cavités 51 de volume V₂ tel que V₂<V₁.

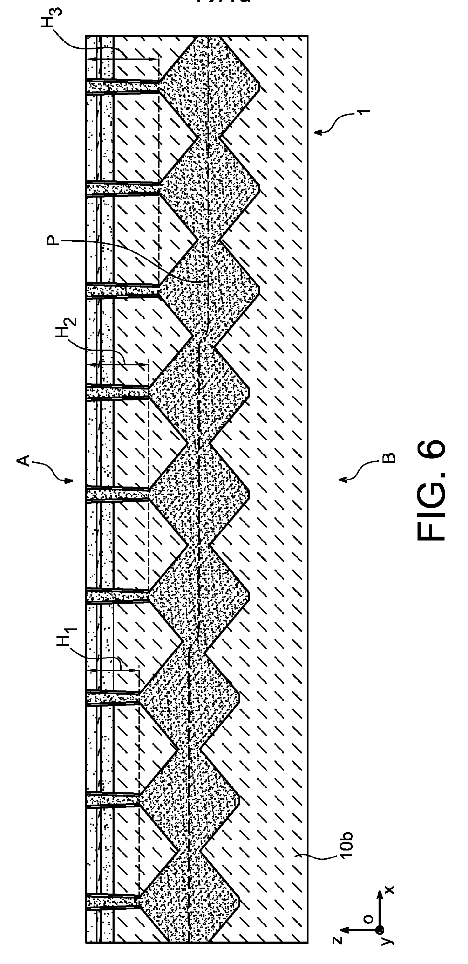

Dans l'exemple de la figure 6, les cavités communiquent avec des tranchées de profondeurs respectives H₁, H₂, H₃ différentes, de sorte que les cavités se situent à des profondeurs différentes par rapport à la face avant A du substrat 1.

Les cavités adjacentes ou voisines réalisées dans le substrat communiquent entre elles de sorte que l'ensemble des cavités forme un tunnel continu ou une galerie continue qui s'étend sur toute la surface du substrat 1 (mesurée ici dans un plan [O ;x ;y] sur la figure 6). Etant donné la différence de profondeur entre les cavités, la galerie isolante réalise un profil P en forme de marches ou en forme d'escalier.

On peut ainsi retirer ultérieurement une portion 10b de la couche de support 10 au niveau de la face arrière B du substrat 1 d'épaisseur variable et qui suit ce profil.

Un tel mode de réalisation peut être mis en oeuvre par exemple lorsque le dispositif microélectronique que l'on fabrique à partir du substrat 1 est un photo-détecteur comportant des cellules destinées à détecter différentes longueurs d'ondes, correspondant à différentes épaisseurs d'une portion 10a du substrat que l'on souhaite conserver et dans laquelle se trouve la couche active, entre la face avant A et les cavités.

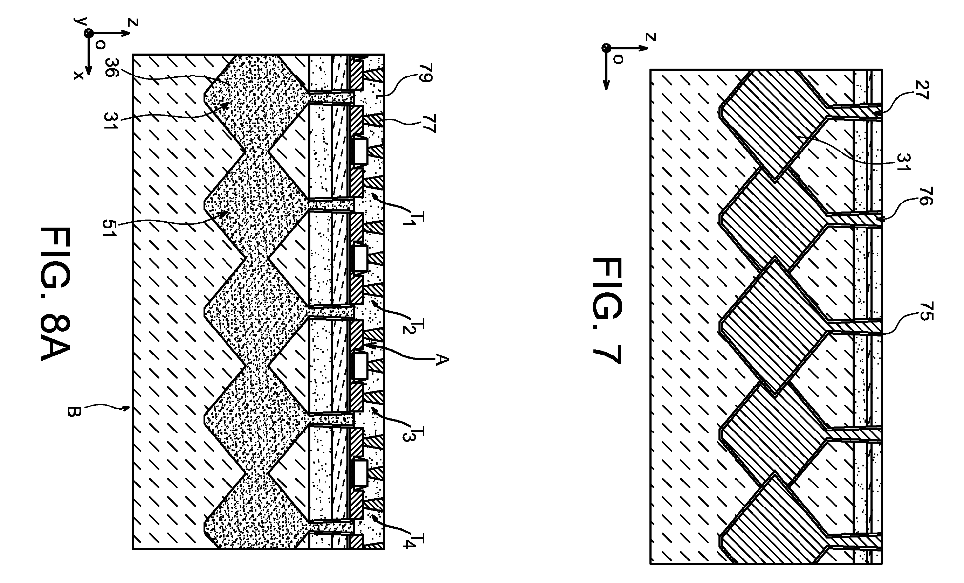

Une autre variante de réalisation est illustrée sur la figure 7. Pour cette variante, le matériau de remplissage des tranchées 27 et des cavités 31 est un matériau métallique 76 tel que par exemple du Tungstène, du Cuivre, ou un matériau conducteur tels que ceux utilisés pour le remplissage d'éléments d'interconnexions TSV (TSV pour « Through Silicon Via »).

Dans ce cas, préalablement au remplissage des tranchées 27 et des cavités 41, une couche barrière 75, par exemple à base de TaN peut être formée de manière à tapisser les parois des tranchées et des cavités. Cette couche barrière 75 permet d'empêcher une diffusion métallique dans le substrat 1. Une telle variante peut permettre de mettre en oeuvre un substrat 1 aminci avec une face arrière recouverte de matériau métallique 76.

Un autre exemple de mise en oeuvre d'un procédé suivant l'invention est illustré sur les figures 8A-8D.

Dans cet exemple, des composants ont été réalisés en partie dans la couche semi-conductrice 13 du substrat 1 formant une couche active, et ce préalablement à l'étape consistant à retirer une portion du substrat 1 par sa face arrière B et telle que décrite précédemment en liaison avec les figures 2B-2C ou avec les figures 3D-3E. Les composants formés du côté de la face avant A du substrat 1 sont dans cet exemple des transistors T₁, T₂, T₃, T₄, sur lesquels des contacts 77 sont prévus et formés dans une couche 79 protectrice recouvrant la couche active en face avant A du substrat 1.

Cette couche protectrice 79 est à base d'un matériau qui peut être diélectrique, et différent du matériau de remplissage 36, 56 des cavités 31, 51, de préférence un matériau choisi de manière à pouvoir résister à une gravure du matériau de remplissage 36, 56 des cavités 31, 51. La couche protectrice 79 peut être par exemple à base de nitrure de silicium (SiₓN_{y}) lorsque les cavités 31, 51 sont remplies de SiO₂ (Figure 8A).

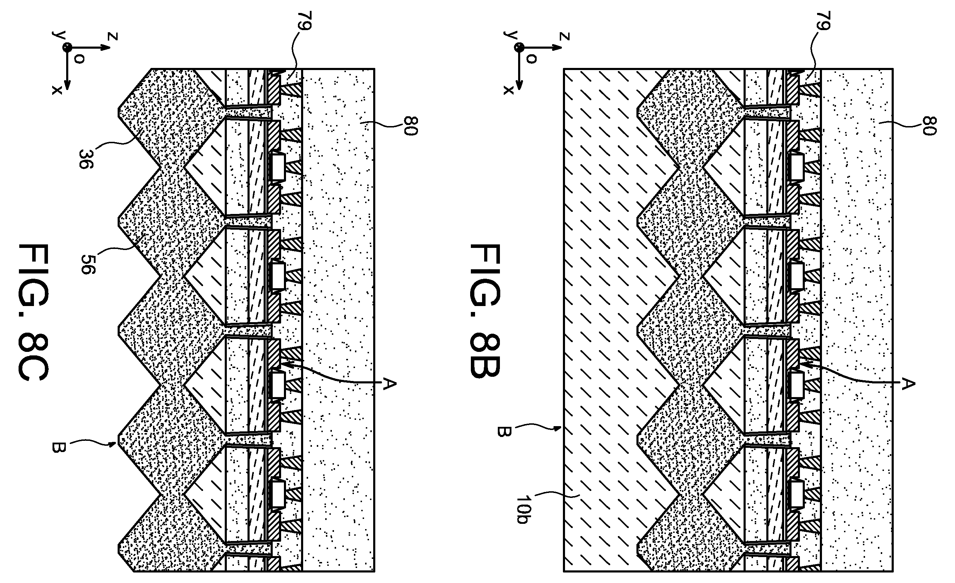

Ensuite, on accole à la couche protectrice 79, un support poignée 80. Ce support poignée 80 est ainsi disposé du côté de la face avant A du substrat 1, et peut être par exemple à base de matériau polymère (Figure 8B).

En variante, le support poignée 80 peut être un substrat recouvert d'une couche d'oxyde de silicium. Dans ce cas, l'assemblage du support poignée 80 et de la couche protectrice 79 peut être réalisé par le biais d'un collage direct tel que par exemple un collage de type oxyde/oxyde, c'est à dire d'une couche d'oxyde disposée sur le support sur une couche d'oxyde formée sur la couche protectrice 79, sans colle ou matériau intermédiaire.

Puis, on effectue un retrait d'une portion 10b du substrat 1 du côté de sa face arrière B. Ce retrait est réalisé, par exemple par gravure et/ou par meulage, jusqu'à atteindre le matériau 36, 56 de remplissage des cavités (Figure 8C).

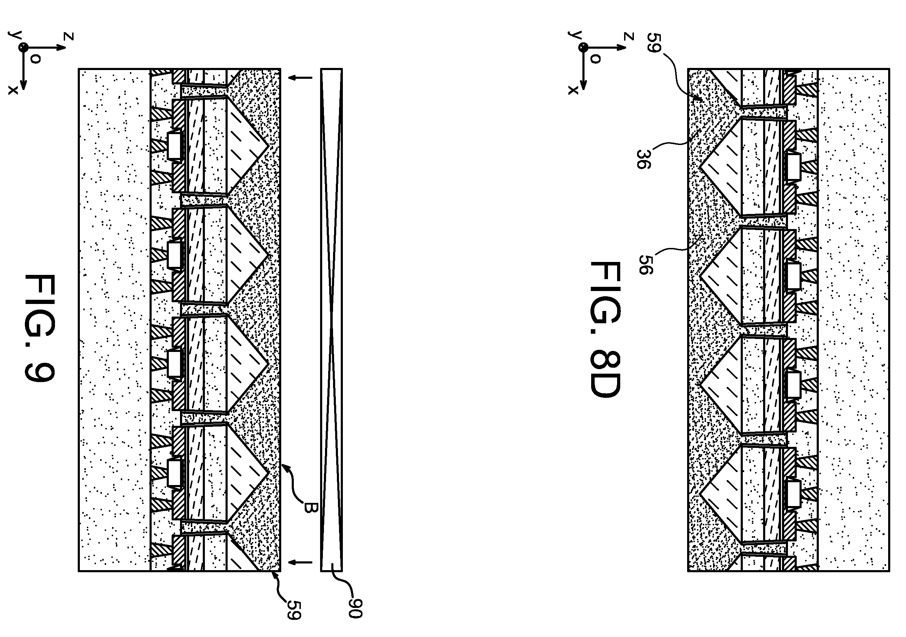

On peut ensuite, du côté de la face arrière B du substrat 1, effectuer un polissage du matériau donné 36, 56, de remplissage des cavités de manière à former une couche 59 plane à base dudit matériau donné 36,56, (figure 8D).

Ensuite, selon une première possibilité, on peut effectuer un assemblage de la couche 59 rendue plane avec un autre dispositif 90, tel qu'un autre support 90, ou un autre substrat 90 qui peut éventuellement comporter d'autres composants (Figure 9). L'assemblage peut être réalisé par le biais d'une technique de collage moléculaire entre une couche de SiO₂ et une autre couche de SiO₂ (collage oxyde/oxyde) entre lesquelles des liaisons hydrogène sont établies.

Selon une deuxième possibilité, après la planarisation de la face arrière, on peut déposer une ou plusieurs couches sur la couche 59 de matériau 36, 56 en face arrière B du substrat 1. Par exemple, dans le cas où le dispositif fabriqué sur le substrat est de type optoélectronique, et comporte par exemple des cellules photo-détectrices, une couche 93 anti reflet peut être déposée sur la couche 59 rendue plane (Figure 10).

Selon une autre possibilité de mise en oeuvre (figure 11), après avoir rendu plane la couche 59 en face arrière B du substrat 1, ou après l'étape de retrait de la portion 10b du substrat décrite précédemment en liaison avec la figure 8C, on peut retirer le matériau de remplissage 36, 56 des tranchées et des cavités. Pour cela on effectue une gravure de ce matériau 36, 56, par la face arrière B du substrat 1 en s'arrêtant sur la couche protectrice 79. Une telle gravure peut permettre de dévoiler des portions restantes de la couche de support 10 semi-conductrice du substrat 1, sous forme de blocs 92 de matériau semi-conducteur situés en regard des composants T₁, T₂, T₃, T₄ formés dans et sur la couche active du substrat. Ces blocs restants 92 peuvent avoir par exemple une forme de pyramide lorsque les cavités 31, 51 ont été réalisées à l'aide d'un procédé tel que décrit précédemment en liaison avec la figure 1E.

Dans un cas, par exemple, où le dispositif microélectronique réalisé est un dispositif ayant une fonction d'imageur ou un circuit imageur, les blocs 92 restants de la couche de support 10 du substrat 1 peuvent être prévus pour former des dioptres, en particulier des lentilles.

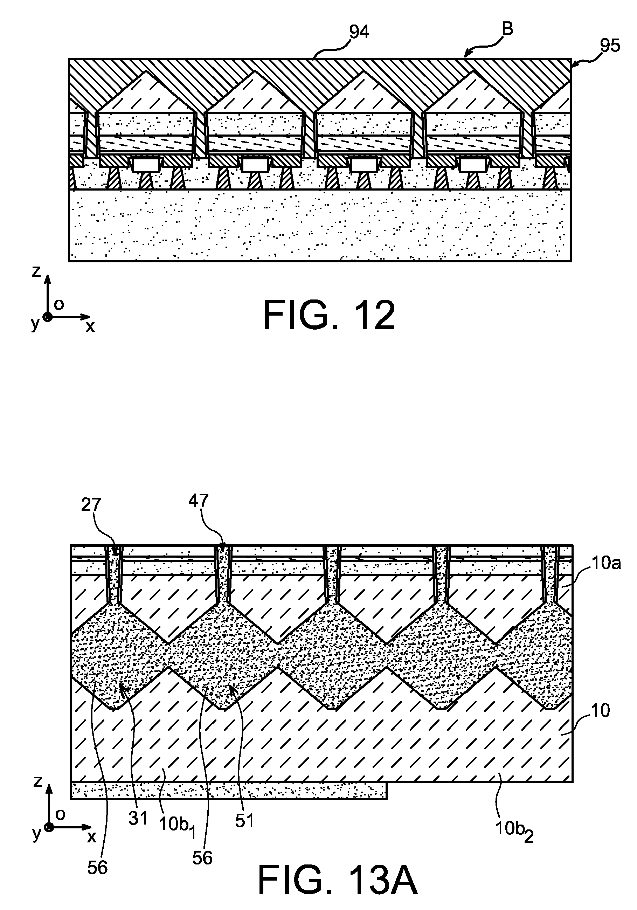

Selon une variante illustrée sur la figure 12, après l'étape de retrait du matériau de remplissage 36, 56 des tranchées et des cavités par la face arrière B du substrat 1, on peut combler à nouveau ces tranchées et ces cavités à l'aide d'un autre matériau 94. Cet autre matériau 94 peut être métallique, par exemple du cuivre. Une étape de planarisation du matériau métallique 94 peut alors être réalisée, par exemple par polissage CMP, de manière à former une couche 95 plane de matériau métallique 94 en face arrière B du substrat 1. Cette couche 95 de matériau métallique 94 peut être prévue pour permettre de prendre un contact électrique sur la face arrière B du substrat 1. Cette couche 95 de matériau métallique 94 peut également servir à réaliser un assemblage avec un autre dispositif ou un autre support ou un autre substrat, en effectuant un collage par exemple un collage moléculaire d'une couche de métal sur une couche de métal, par exemple un collage moléculaire cuivre/cuivre.

Dans l'un ou l'autre des exemples de procédés décrits précédemment, on a retiré une portion 10b du substrat 1 qui s'étend sur toute la surface de la face arrière B de ce dernier, la face arrière B étant intégralement dévoilée lors de la gravure.

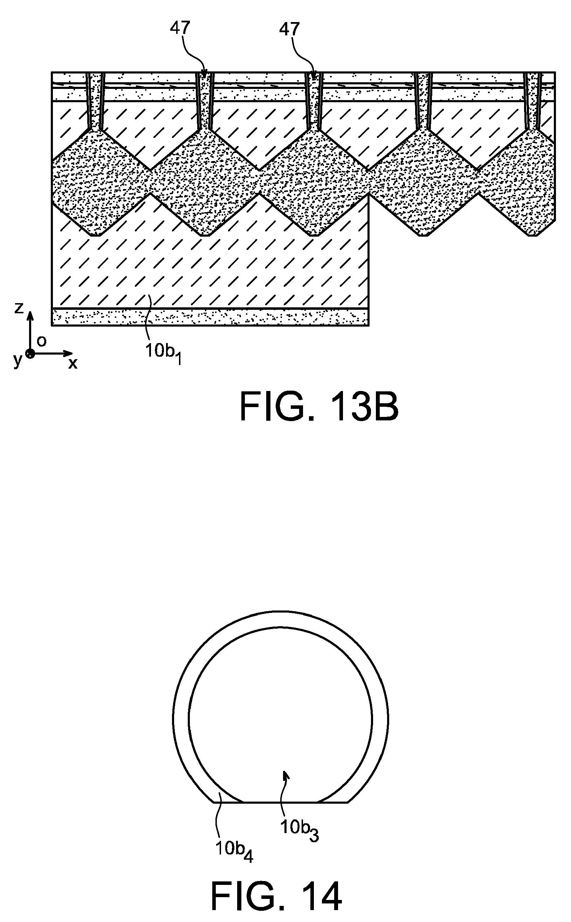

Selon une variante illustrée sur les figures 13A, 13B, on peut retirer uniquement une zone localisée du substrat du côté de sa face arrière B.

Pour cela, après avoir réalisé les tranchées 27, 47 et les cavités 31, 51 remplies de matériau 36, 56, on forme un masquage 99 du côté de la face arrière B du substrat 1 recouvrant une première région 10b1 de la portion donnée 10b de la couche de support 10 tout en dévoilant une deuxième région 10b2 localisée de la portion donnée 10b de la couche de support 10 (figure 13A).

On effectue ensuite une gravure de la couche de support 10 du côté de la face arrière B, afin de retirer la deuxième région 10b2 qui n'est pas protégée par le masquage 99. Cette gravure est prolongée jusqu'à atteindre le matériau de remplissage 36, 56 des cavités 31, 51 (figure 13B). La première région 10b1 localisée au niveau de la face arrière B du substrat 1 est ainsi conservée intacte.

Le procédé suivant l'invention peut être ainsi mis en oeuvre pour permettre d'isoler, ou séparer une partie active d'un substrat, d'une portion de support, cette portion de support pouvant s'étendre sur toute la face arrière du substrat ou peut être une zone localisée de la face arrière du substrat.

Une isolation ou une séparation à l'échelle d'une plaque (wafer) ou à l'échelle d'une ou plusieurs puces d'une même plaque, ou à l'échelle d'un certain nombre de composants d'une puce peut être ainsi réalisée.

Selon une variante de réalisation du procédé (figure 14), on peut retirer uniquement une portion centrale 10b3 de la face arrière B du substrat, en mettant en oeuvre un polissage localisé, par exemple du type de celui mis en oeuvre dans un procédé de type TAIKO™.

Le polissage du substrat au niveau de sa face arrière est alors réalisé jusqu'à atteindre le matériau de remplissage des cavités et servant de ce matériau de remplissage comme matériau d'arrêt au polissage.

Une zone périphérique 10b4 de ladite portion centrale et formant un anneau de la portion centrale retirée, est quant à elle conservée et sert à assurer la cohésion du substrat.

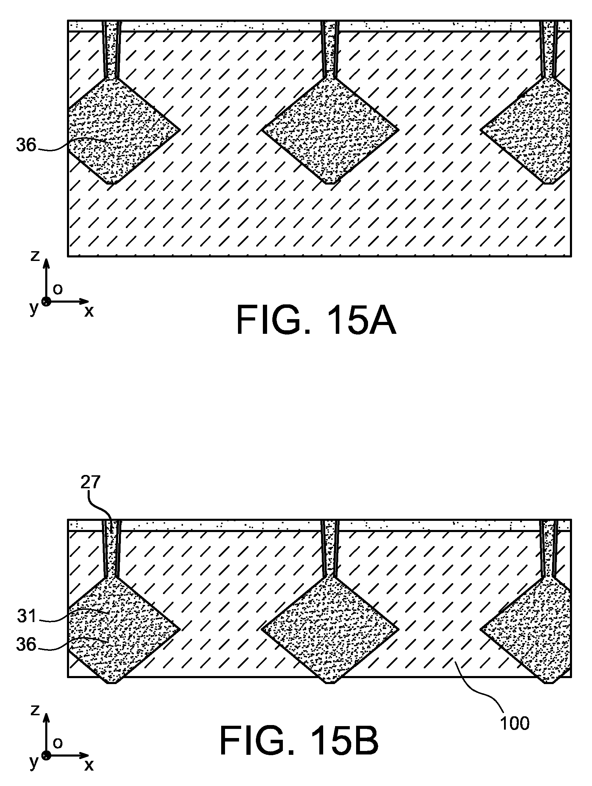

Les exemples de réalisation qui ont été donnés précédemment peuvent également s'adapter à d'autres substrats qu'un substrat de type semi-conducteur sur isolant.
Un autre exemple de réalisation est illustré sur les figures 15A-15B avec un substrat massif 100 (ou « bulk » selon la terminologie anglo-saxonne) dans lequel des cavités 31 formées dans le prolongement de tranchées 27 sont réalisées et remplies d'un matériau donné 36.

L'agencement des tranchées 27 et des cavités 31 est dans cet exemple tel que des cavités adjacentes ne sont pas jointives entre elles (figure 15A). Les cavités 31 sont réalisées de manière à occuper une surface mesurée parallèlement au plan principal du substrat comprise entre 20 % et 90 % de la surface totale de la face arrière B du substrat 100 mesurée également parallèlement au plan principal du substrat.

De cette manière, on peut effectuer un amincissement du substrat 100 par sa face arrière, par exemple par polissage en se servant des cavités 31 remplies par le matériau 36 comme zones d'arrêt au polissage (figure 15B).

L'invention trouve notamment des applications dans le domaine de la fabrication d'imageurs, tels que les imageurs UTBB c'est-à-dire formés sur un substrat comprenant une couche active ultra-mince, par exemple inférieure à 1 µm et une couche isolante ultra-mince par exemple inférieure à 50 nm.

## Revendications

1. Procédé de réalisation d'un dispositif microélectronique comprenant des étapes consistant à :
- réaliser une pluralité de tranchées (27, 47) du côté d'une face avant (A) d'un substrat (1), comportant une zone active (13) dans laquelle un ou plusieurs composants (T₁, T₂, T₃, T₄) sont prévus,
- former dans le prolongement desdites tranchées, des cavités (31, 51) élargies par rapport aux tranchées (27,47) de sorte qu'au moins une cavité donnée (51) formée dans le prolongement d'une tranchée donnée (47), est réalisée à côté d'une autre cavité (31) formée dans le prolongement d'une autre tranchée (27) adjacente de ladite tranchée donnée (47),
- remplir lesdites cavités (31, 51) à l'aide d'au moins un matériau donné (36, 56, 66, 76),
lesdites cavités formant une séparation entre ladite zone active et une portion du substrat située au niveau de sa face arrière, le procédé comprenant en outre une étape consistant à retirer, au moins une portion donnée (10b, 10b2, 10b1) du substrat, à base d'un autre matériau différent dudit matériau donné (36, 56, 66, 76) et située entre sa face arrière (B), opposée à ladite face avant (A), et lesdites cavités.

2. Procédé selon la revendication 1, dans lequel l'étape de retrait de ladite portion donnée (10b) du substrat (1) comprend une gravure sélective dudit autre matériau du substrat vis-à-vis dudit matériau donné (36, 56) de remplissage des cavités ou un retrait dudit autre matériau du substrat jusqu'à atteindre ledit matériau donné (36, 56) de remplissage des cavités, ledit matériau donné servant de matériau d'arrêt.

3. Procédé de réalisation d'un dispositif microélectronique selon la revendication 2, dans lequel le retrait de ladite portion donnée (10b2) 10b2) du substrat (1) est réalisé par :
- formation d'un masquage (99) protégeant une zone donnée de la face arrière (B) du substrat (1), une autre zone (10b2) de la face arrière étant dévoilée,
- gravure de cette autre zone (10b2) à travers le masquage (99).

4. Procédé selon la revendication 2, dans lequel ladite portion donnée (10b) du substrat (1) est une portion centrale du substrat, le retrait étant effectué par polissage dudit autre matériau du substrat jusqu'à atteindre ledit matériau donné (36, 56) de remplissage des cavités (B) du substrat, ledit matériau donné servant de matériau d'arrêt au polissage, une zone du substrat périphérique à ladite portion centrale étant conservée.

5. Procédé selon l'une des revendications 2 à 4, le procédé comprenant en outre après ce retrait : une étape de planarisation dudit matériau donné (36, 56) par la face arrière (B) du substrat.

6. Procédé selon la revendication 5, comprenant en outre, après planarisation dudit matériau donné (36, 56) : une étape consistant à déposer au moins une couche du côté de la face arrière (B) du substrat (1), en particulier une couche anti-réfléchissante (93).

7. Procédé selon la revendication 5, comprenant en outre, après planarisation dudit matériau donné (36, 56), une étape consistant à assembler, en particulier par collage moléculaire, un support (90) du côté de la face arrière (B) dudit substrat (1).

8. Procédé selon l'une des revendications 1 à 5, comprenant en outre, après retrait de ladite portion donnée (10b) du substrat (1) : une étape de retrait dudit matériau donné (36, 56).

9. Procédé de réalisation d'un dispositif microélectronique imageur selon la revendication 8, dans lequel le retrait du matériau de remplissage est effectué de manière à dévoiler des blocs du substrat (1) destinés à former des lentilles.

10. Procédé selon la revendication 8, dans lequel après avoir retiré le matériau donné (36,56) des cavités (31,51) et des tranchées (37,57), on remplace le matériau donné par un matériau conducteur (94).

11. Procédé selon la revendication 1, dans lequel une ou plusieurs desdites cavités sont formées de manière à déboucher latéralement sur une zone (4,5) d'une face latérale du substrat, de sorte que le matériau donné (66) de remplissage est accessible par cette zone, l'étape de retrait de ladite portion donnée (10b) du substrat comprenant une gravure sélective du matériau donné (66) vis-à-vis dudit autre matériau du substrat (1).

12. Procédé de réalisation d'un dispositif microélectronique selon l'une des revendications 1 à 11, dans lequel ladite cavité (51) donnée communique latéralement avec ladite autre cavité (31) et forme avec cette autre cavité une galerie dans ledit substrat, le remplissage desdites cavités (31, 51) étant réalisé de sorte que ladite galerie est remplie dudit matériau donné et forme une séparation entre la dite zone active (13) et ladite portion donnée (10b, 10b2, 10b1) du substrat (1).

13. Procédé de réalisation d'un dispositif microélectronique selon la revendication 12, dans lequel les étapes consistant à réaliser lesdites tranchées, former lesdites cavités élargies par rapport aux tranchées, et remplir lesdites cavités comprennent :
- la réalisation d'une première pluralité de tranchées (27) du côté de la face avant du substrat,
- la formation dans le prolongement desdites premières tranchées, de premières cavités (31) élargies par rapport aux premières tranchées,
- le remplissage desdites premières cavités (31) à l'aide dudit matériau donné (36),
- la réalisation d'une deuxième pluralité de tranchées (47) du côté de la face avant du substrat,
- la formation dans le prolongement desdites deuxièmes tranchées, de deuxièmes cavités (51) élargies par rapport aux deuxièmes tranchées,
- le remplissage desdites deuxièmes cavités à l'aide dudit matériau donné (56).

14. Procédé selon l'une des revendications 1 à 13, comprenant en outre, après remplissage des cavités (31,51) à l'aide dudit matériau donné (66), la formation d'au moins une couche protectrice (69, 79) sur la face avant (A) du substrat (1) et bouchant lesdites tranchées (27, 47), le matériau donné (66) de remplissage étant apte à être gravé de manière sélective vis-à-vis de celui de ladite couche protectrice (69,79).

15. Procédé selon l'une des revendications 1 à 14, comprenant en outre après remplissage des cavités (31,51) et préalablement au retrait de ladite portion (10b) du substrat (1), au moins un recuit de densification du matériau donné (36, 56, 66) de remplissage desdites cavités.

16. Procédé selon l'une des revendications 1 à 15, comprenant en outre après remplissage des cavités et préalablement au retrait de ladite portion (10b) du substrat, un assemblage d'un substrat poignée (80) en face avant (A) du substrat (1).

17. Procédé selon l'une des revendications 1 à 16, dans lequel ladite tranchée donnée et ladite tranchée adjacente sont espacées d'une distance p prédéterminée, les cavités étant formées par gravure du substrat (1) prolongée de sorte que les cavités comportent des parois (33a, 33b) réalisant une forme évasée, la distance Δ séparant les parois atteignant une valeur, telle que Δ>p.

18. Procédé selon l'une des revendications 1 à 17, dans lequel ladite portion (10b) retirée du substrat (1) est à base de Si d'orientation cristallographique '(100)', les cavités (31,51) étant formées par gravure selon le plan cristallographique '(111)'.

19. Procédé selon l'une des revendications 1 à 18, dans lequel le matériau donné (36, 56, 66) de remplissage des cavités est un matériau diélectrique tel que du SiO₂.

20. Procédé selon l'une des revendications 1 à 18, dans lequel le matériau de remplissage donné (76) de remplissage des cavités est un métal, le procédé comprenant en outre après formation des cavités et préalablement à leur remplissage, une étape consistant à former une couche barrière de diffusion (75) tapissant les parois des cavités.

21. Procédé selon l'une des revendications 1 à 20, dans lequel plusieurs desdites cavités sont situées à des profondeurs différentes dans le substrat (1).

## Patentansprüche

1. Verfahren zur Herstellung einer mikroelektronischen Vorrichtung, umfassend die folgenden Schritte:
- Realisieren einer Mehrzahl von Gräben (27, 47) auf der Seite einer Vorderfläche (A) eines Substrats (1), umfassend eine aktive Zone (13), in der ein oder mehrere Komponenten (T₁, T₂, T₃, T₄) vorgesehen sind,
- Bilden, in der Verlängerung der Gräben, von Hohlräumen (31, 51), die bezogen auf die Gräben (27, 47) derart verbreitert sind, dass wenigstens ein gegebener Hohlraum (51), der in der Verlängerung eines gegebenen Grabens (47) gebildet ist, neben einem anderen Hohlraum (31) realisiert ist, der in der Verlängerung eines anderen Grabens (27) gebildet ist, der dem gegebenen Graben (47) benachbart ist,
- Füllen der Hohlräume (31, 51) mit Hilfe wenigstens eines gegebenen Materials (36, 56, 66, 76), wobei die Hohlräume eine Separation zwischen der aktiven Zone und einem Bereich des Substrats bilden, der im Bereich seiner Rückfläche liegt,
wobei das Verfahren ferner einen Schritt umfasst, der darin besteht, wenigstens einen gegebenen Bereich (10b, 10b2, 10b1) des Substrats auf Basis eines anderen Materials zu entfernen, das von dem gegebenen Material (36, 56, 66, 76) verschieden ist und zwischen seiner Rückfläche (B), entgegengesetzt zur Vorderfläche (A), und den Hohlräumen liegt.

2. Verfahren nach Anspruch 1, bei dem der Schritt des Entfernens des gegebenen Bereichs (10b) des Substrats (1) ein selektives Gravieren des anderen Materials des Substrats bezogen auf das gegebene Material (36, 56) zum Füllen der Hohlräume umfasst, oder ein Entfernen des anderen Materials des Substrats, bis das gegebene Material (36, 56) zum Füllen der Hohlräume erreicht wird, wobei das gegebene Material als Stoppmaterial dient.

3. Verfahren zur Herstellung einer mikroelektronischen Vorrichtung nach Anspruch 2, bei dem das Entfernen des gegebenen Bereichs (10b2) des Substrats (1) realisiert wird durch:
- Bilden einer Maske (99), die eine gegebene Zone der Rückfläche (B) des Substrats (1) schützt, wobei eine andere Zone (10b2) der Rückfläche frei liegt,
- Gravieren dieser anderen Zone (10b2) durch die Maske (99) hindurch.

4. Verfahren nach Anspruch 2, bei dem der gegebene Bereich (10b) des Substrats (1) ein zentraler Bereich des Substrats ist, wobei das Entfernen durch Polieren des anderen Materials des Substrats durchgeführt wird, bis das gegebene Material (36, 56) zum Füllen der Hohlräume (B) des Substrats erreicht wird, wobei das gegebene Material als Stoppmaterial für das Polieren dient, wobei eine Zone des Substrats um den zentralen Bereich herum beibehalten wird.

5. Verfahren nach einem der Ansprüche 2 bis 4, wobei das Verfahren ferner nach diesem Entfernen einen Schritt des Planarisierens des gegebenen Materials (36, 56) von der Rückfläche (B) des Substrats her umfasst.

6. Verfahren nach Anspruch 5, ferner umfassend, nach dem Planarisieren des gegebenen Materials (36, 56), einen Schritt, der darin besteht, wenigstens eine Schicht auf der Seite der Rückfläche (B) des Substrats (1) aufzubringen, insbesondere eine Antireflexschicht (93).

7. Verfahren nach Anspruch 5, ferner umfassend, nach dem Planarisieren des gegebenen Materials (36, 56), einen Schritt, der darin besteht, insbesondere durch molekulares Kleben einen Träger (90) auf der Seite der Rückfläche (B) des Substrats (1) anzubringen.

8. Verfahren nach einem der Ansprüche 1 bis 5, ferner umfassend, nach dem Entfernen des gegebenen Bereichs (10b) des Substrats (1), einen Schritt des Entfernens des gegebenen Materials (36, 56).

9. Verfahren zur Herstellung einer mikroelektronischen Bildgebungsvorrichtung nach Anspruch 8, bei dem das Entfernen des Materials zum Füllen derart durchgeführt wird, dass Blöcke des Substrats (1) freigelegt werden, die dazu ausgelegt sind, Linsen zu bilden.

10. Verfahren nach Anspruch 8, bei dem man nach dem Entfernen des gegebenen Materials (36, 56) aus den Hohlräumen (31, 51) und den Gräben (37, 57) das gegebene Material durch ein leitendes Material (94) ersetzt.

11. Verfahren nach Anspruch 1, bei dem einer oder mehrere der Hohlräume derart gebildet sind, dass sie lateral in eine Zone (4, 5) einer lateralen Fläche des Substrats derart münden, dass das gegebene Material (66) zum Füllen von dieser Zone her zugänglich ist, wobei der Schritt des Entfernens des gegebenen Bereichs (10b) des Substrats ein selektives Gravieren des gegebenen Materials (66) bezüglich des anderen Materials des Substrats (1) umfasst.

12. Verfahren zur Herstellung einer mikroelektronischen Vorrichtung nach einem der Ansprüche 1 bis 11, bei dem der gegebene Hohlraum (51) lateral mit dem anderen Hohlraum (31) kommuniziert und mit diesem anderen Hohlraum eine Galerie in dem Substrat bildet, wobei das Füllen der Hohlräume (31, 51) derart realisiert wird, dass die Galerie mit dem gegebenen Material gefüllt wird und eine Separation zwischen der aktiven Zone (13) und dem gegebenen Bereich (10b, 10b2, 10b1) des Substrats (1) bildet.

13. Verfahren zur Herstellung einer mikroelektronischen Vorrichtung nach Anspruch 12, bei dem die Schritte des Realisierens der Gräben, des Bildens der bezüglich der Gräben verbreiterten Hohlräume und des Füllens der Hohlräume umfassen:
- das Realisieren einer ersten Mehrzahl von Gräben (27) auf der Seite der Vorderfläche des Substrats
- das Bilden, in der Verlängerung der ersten Gräben, von ersten Hohlräumen (31), die bezüglich der ersten Gräben verbreitert sind,
- das Füllen der ersten Hohlräume (31) mit Hilfe des gegebenen Materials (36),
- das Realisieren einer zweiten Mehrzahl von Gräben (47) auf der Seite der Vorderfläche des Substrats,
- das Bilden, in der Verlängerung der zweiten Gräben, von zweiten Hohlräumen (51), die bezüglich der zweiten Gräben verbreitert sind,
- das Füllen der zweiten Hohlräume mit Hilfe des gegebenen Materials (56).

14. Verfahren nach einem der Ansprüche 1 bis 13, ferner umfassend, nach dem Füllen der Hohlräume (31, 51) mit Hilfe des gegebenen Materials (66), das Bilden wenigstens einer Schutzschicht (69, 79) auf der Vorderfläche (A) des Substrats (1) und Verschließen der Gräben (27, 47), wobei das gegebene Material (66) zum Füllen dazu ausgelegt ist, in selektiver Weise bezüglich jenem der Schutzschicht (69, 79) graviert zu werden.

15. Verfahren nach einem der Ansprüche 1 bis 14, ferner umfassend, nach dem Füllen der Hohlräume (31, 51) und vor dem Entfernen des Bereichs (10b) des Substrats (1) wenigstens ein Glühen zum Verdichten des gegebenen Materials (36, 56, 66) zum Füllen der Hohlräume.

16. Verfahren nach einem der Ansprüche 1 bis 15, ferner umfassend, nach dem Füllen der Hohlräume und vor dem Entfernen des Bereichs (10b) des Substrats, ein Anbringen eines Griffsubstrats (80) an der Vorderfläche (A) des Substrats (1).

17. Verfahren nach einem der Ansprüche 1 bis 16, bei dem der gegebene Graben und der benachbarte Graben um einen vorbestimmten Abstand p beabstandet sind, wobei die Hohlräume durch verlängertes Gravieren des Substrats (1) derart gebildet werden, dass die Hohlräume Wände (33a, 33b) umfassen, die eine aufgeweitete Form realisieren, wobei der Abstand Δ, der die Wände voneinander trennt, einen Wert derart erreicht, dass Δ>p.

18. Verfahren nach einem der Ansprüche 1 bis 17, bei dem der entfernte Bereich (10b) des Substrats (1) auf Basis von Si mit kristallographischer Orientierung (100) ist, wobei die Hohlräume (31, 51) durch Gravieren entlang der kristallographischen Ebene (111) gebildet werden.

19. Verfahren nach einem der Ansprüche 1 bis 18, bei dem das gegebene Material (36, 56, 66) zum Füllen der Hohlräume ein dielektrisches Material wie zum Beispiel SiO₂ ist.

20. Verfahren nach einem der Ansprüche 1 bis 18, bei dem das gegebene Füllmaterial (76) zum Füllen der Hohlräume ein Metall ist, wobei das Verfahren ferner nach dem Bilden der Hohlräume und vor ihrem Füllen einen Schritt des Bildens einer Diffusionsbarriereschicht (75) umfasst, die die Wände der Hohlräume bedeckt.

21. Verfahren nach einem der Ansprüche 1 bis 20, bei dem mehrere der Hohlräume an unterschiedlichen Tiefen in dem Substrat (1) angeordnet sind.

## Claims

1. A Method for fabricating a microelectronic device comprising steps to:
- making a plurality of trenches (27, 47) on the front face (A) of a substrate (1), comprising an active zone (13) in which one or several components (T₁, T₂, T₃, T₄) are provided,
- forming cavities (31, 51) widerthan the trenches (27,47) to extend said trenches, such that at least one given cavity (51) formed to extend a given trench (47), is made adjacent to another cavity (31) formed to extend another trench (27) adjacent to said given trench (47),
- filling said cavities (31, 51) with at least one given material (36, 56, 66, 76), said cavities forming a separation between said active zone and a substrate portion situated at its back face,
the method further including a step consisting of removing at least a given portion (10b, 10b2, 10b1) of the substrate, based on another material different from said given material (36, 56, 66, 76) and located between its back face (B), opposite said front face (A), and said cavities.

2. The method according to claim 1, wherein the step to remove said given portion (10b) of the substrate (1) comprises selective etching of said other material of the substrate relative to said given cavity infill material (36, 56) or removal of said other material of the substrate until said given cavity infill material (36, 56) is reached, said given material being an etch stop material.

3. The method according to claim 2, wherein removal of said given portion (10b2) 10b2) of the substrate (1) comprises the steps consisting of:
- forming a mask (99) protecting a given zone of the back face (B) of the substrate (1), another zone (10b2) of the back face being exposed,
- etching of this other zone (10b2) through the mask (99).

4. The method according to claim 2, in which said given portion (10b) of the substrate (1) is a central portion of the substrate, removal being done by planarizing said other material of the substrate until reaching said given infill material (36, 56) that fills the cavities (B) of the substrate, said given material being a planarization stop material, a peripheral zone of the substrate around said central portion being kept.

5. The method according to any one of claims 2 to 4, the method further including a step of planarizing said given material (36, 56) on the back face (B) of the substrate after this removal.

6. The method according to claim 5, also including a step after planarization of said given material (36, 56) consisting of depositing at least one layer on the side of the back face (B) of the substrate (1), particularly an anti-reflecting layer (93).

7. The method according to claim 5, also including a step after planarisation of said given material (36, 56), to assemble a support (90) on the back face (B) of said substrate (1), particularly by molecular bonding.

8. The method according to one of claims 1 to 5, also including a step after removal of said given portion (10b) of the substrate (1) to remove said given material (36, 56).

9. The method for fabricating the microelectronic device according to claim 8, the microelectronic device being an imager wherein the infill material is removed so as to expose blocks of the substrate (1) designed to form lenses.

10. The method according to claim 8, wherein after removing the given material (36,56) from cavities (31,51) and trenches (37,57), the given material is replaced by a conducting material (94).

11. The method according to claim 1, in which one or several of said cavities are formed so as to open up laterally into a zone (4,5) of a side face of the substrate, such that the given infill material (66) is accessible from this zone, the step for removing said given portion (10b) of the substrate including selective etching of the given material (66) relative to said other material of the substrate (1).

12. The method of manufacturing a microelectronic device according to any of claims 1 to 11, in which said given cavity (51) communicates laterally with said other cavity (31) and forms a tunnel in said substrate with this other cavity, said cavities (31, 51) being filled such that said tunnel is filled with said given material and forms a separation between said active zone (13) and said given portion (10b, 10b2, 10b1) of the substrate (1).

13. The method of manufacturing a microelectronic device according to claim 12, wherein steps consisting of making said trenches, forming said widened cavities and filling said cavities include the following:
- making a first plurality of trenches (27) on the front face of the substrate,
- forming first cavities (31) wider than the first trenches to extend said first trenches,
- filling in said first cavities (31) using said given material (36),
- making a second plurality of trenches (47) on the front face of the substrate,
- forming second cavities (51) wider than the second trenches to extend said second trenches,
- filling in said second cavities using said given material (56).

14. The method according to one of claims 1 to 13, also including the formation of at least one protective layer (69, 79) on the front face (A) of the substrate (1) and closing said trenches (27, 47) after the cavities (31,51) have been filled using said given material (66), making it possible to etch the given infill material (66) selectively relative to the material of the protective layer (69,79).

15. The method according to one of claims 1 to 14, further including at least annealing to increase the density of the given material (36, 56, 66) after the cavities (31,51) have been filled and before said portion (10b) of the substrate (1) has been removed.

16. The method according to one of claims 1 to 15, further including assembly of a handle substrate (80) on the front face (A) of the substrate (1) after the cavities have been filled and before said portion (10b) of the substrate has been removed.

17. The method according to one of claims 1 to 16, wherein said given trench and said adjacent trench have a predetermined spacing p, the cavities being formed by etching the substrate (1), etching being prolonged such that cavities comprise walls (33a, 33b) forming a tapered shape, the distance Δ separating the walls being equal to a value such that Δ>p.

18. The method according to one of claims 1 to 17, in which said portion (10b) removed from the substrate (1) is based on Si with '(100)' crystallographic orientation, the cavities (31,51) being formed by etching along the '(111)' crystallographic plane.

19. The method according to one of claims 1 to 18, in which the given cavity infill material (36, 56, 66) is a dielectric material.

20. The method according to one of claims 1 to 18, in which the given cavity infill material (76) is a metal, the method further including a step after formation of the cavities and before they are filled, to form a barrier diffusion layer (75) lining the walls of the cavities.

21. The method according to one of claims 1 to 20, wherein several of said cavities are located at different depths in the substrate (1).
